# EUROPEAN PATENT APPLICATION

(11) **EP 1 024 532 A2**
(43) Date of publication of application: **02.08.2000**
(21) Application number: 99119612.2
(22) Date of filing: 04.10.1999
(51) Int. Cl.: H01L 23/495

(54) **Semiconductor device and method of producing the same**

(30) Priority: 28.01.1999 JP 2045799
(71) Applicant: FUJITSU LIMITED, Kawasaki-shi, Kanagawa 211-8588 (JP)
(72) Inventor: Yurino, Takahiro, c/o Fujitsu Limited, Kawasaki-shi, Kanagawa, 211-8588 (JP)
(74) Representative: Seeger, Wolfgang, Dipl.-Phys.

(57) **Abstract**

A semiconductor device and a method of producing the same are provided. The semiconductor device includes a semiconductor chip, a die pad onto which the semiconductor chip is mounted via a die bonding material, and a resin package which seals at least the semiconductor chip and the die pad. The die pad is provided with bond reinforcing members each including a penetrating portion and a step portion. The step portion is formed within the range of the thickness of the die pad. With the semiconductor chip being mounted on the die pad, spaces are formed between the semiconductor chip and the step portion, and part of the resin package is interposed in the spaces.

## Description

### BACKGROUND OF THE INVENTION

### 1. Field of the Invention

The present invention generally relates to semiconductor devices and a method of producing the same, and, more particularly, to a semiconductor device in which a semiconductor chip mounted on a die pad is sealed by resin, and a method of producing the semiconductor device.

### 2. Description of the Related Art

In recent years, semiconductor devices have been becoming smaller and thinner, and resin packages have been becoming thinner accordingly. Because of this trend, the mechanical strength of resin packages is becoming lower. For instance, separation often occurs between a die pad and a resin package due to the thermal expansion difference between the die pad and the resin package at the time of reflowing or heat application for mounting a semiconductor chip. Also, a resin package often swells due to vapors caused at the interface between the die pad and the resin package.

Because of the above problems, there is an increasing demand for semiconductor devices which have high heat tolerance and high reliability at the time of heat application.

A generally known semiconductor device has a resin package formed by resin molding after attaching a semiconductor chip onto a die pad of a lead frame and wire-bonding the semiconductor chip and the leads. Since the resin of the above resin package absorbs moisture, separation occurs between the resin package and the die pad, or the resin package swells due to the vapors caused at the interface between the resin package and the die pad at the time of heat application for mounting. Also, the thermal expansion difference between the resin package and the die pad might cause separation between the resin package and the die pad at the time of heat application. Die pads are generally made of copper alloy in response to demands for multi-functional thin die pads. However, copper alloy is poor in bonding with resin. If a die pad made of copper alloy is employed, separation might occur between the resin package and the die pad due to the poor bonding.

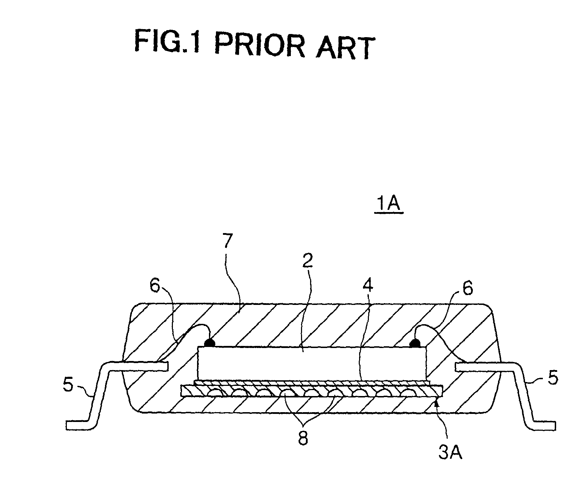

Conventionally, to prevent separation and swelling, the shape of the interface between the die pad and the resin package is changed. FIGs. 1 to 6 show specific examples of means to prevent separation and swelling in the prior art.

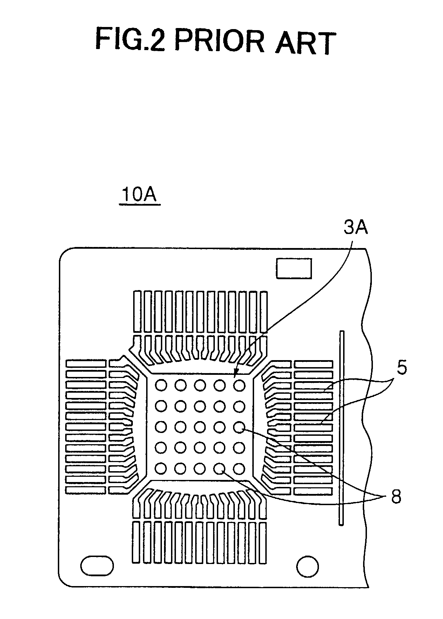

As shown in FIGs. 1 and 2, dimples 8 (hemispherical concavities) are formed at the interface between a die pad 3A and a resin package 7. FIG. 1 shows a semiconductor device 1A having the die pad 3A provided with the dimples 8. FIG. 2 shows a lead frame 10A used for producing the semiconductor device 1A. In this structure, the dimples 8 cut into the resin package, thereby strengthening the bond between the die pad 3A and the resin package 7. Thus, separation between the die pad 3A and the resin package 7 can be avoided, and the resin package 7 can be prevented from swelling.

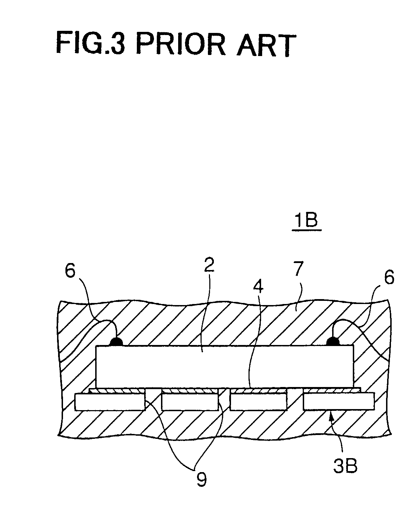

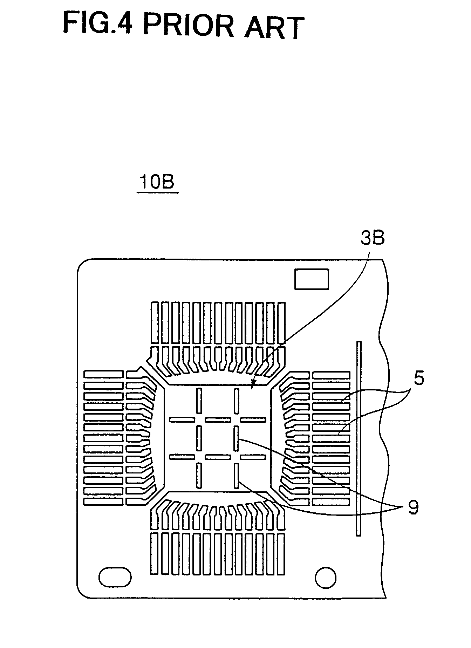

As shown in FIGs. 3 and 4, slits 9 are formed in the die pad 3B, and the resin package 7 is introduced into the slits 9. FIG. 3 is an enlarged view of a semiconductor device 1B having the die pad 3B provided with slits 9. FIG. 4 shows a lead frame 10B used for producing the semiconductor device 1B. In this structure, the slits 9 disperse the stress caused in the die pad 3B at the time of heat application, so that the stress directly applied to the interface between the die pad 3B and the resin package 7 can be reduced. Thus, separation between the die pad 3B and the resin package 7 can be avoided, and the resin package 7 can be prevented from swelling.

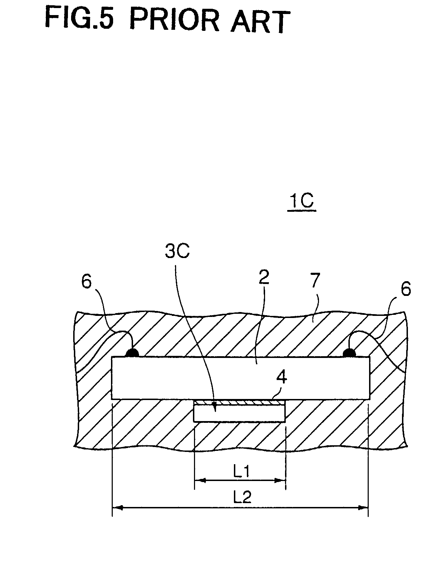

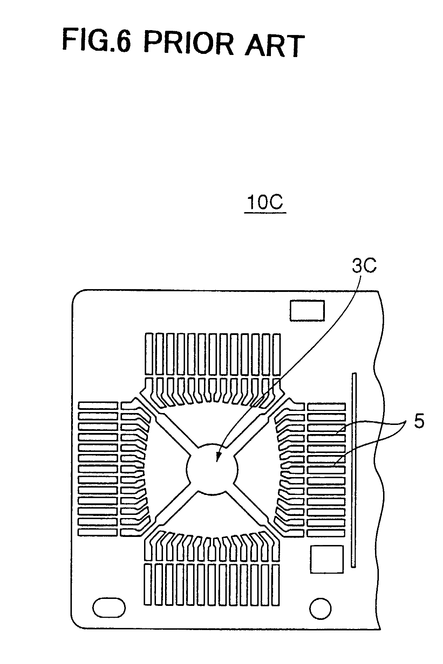

As shown in FIGs. 5 and 6, a die pad 3C is made smaller than a semiconductor chip 2, i.e., the length L1 of the die pad 3C is smaller than the length L2 of the semiconductor chip 2 (L1 < L2).

FIG. 5 is an enlarged view of a semiconductor device 1C having the die pad 3C smaller than the semiconductor chip 2. FIG. 6 is a lead frame 6C used for producing the semiconductor device 1C. In this structure, the bonding area between the die pad 3C and the resin package 7 is smaller than in the structures shown in FIGs. 1 to 4, and the stress caused between the die pad 3C and the resin package 7 is smaller accordingly. Thus, separation between the die pad 3C and the resin package 7 can be avoided, and the resin package 7 can be prevented from swelling.

In FIGs. 1 to 6, reference numeral 4 indicates a die bonding material for bonding the semiconductor chip 2 to the die pad 3A, 3B, or 3C. Reference numeral 5 indicates leads which function as outer connecting terminals, and reference numeral 6 indicates wires which electrically connect the semiconductor chip 2 and the leads 5.

In the semiconductor device 1A shown in FIGs. 1 and 2, it is necessary to form the dimples 8 in the die pad 3A. However, the dimples 8 are formed by etching which costs more than machining. There is another problem that etching is time consuming and has a poor throughput.

In the semiconductor device 1B shown in FIGs. 3 and 4, the stress caused in the die pad 3B at the time of heat application is dispersed by the slits 9 to prevent separation and swelling, but the effects of preventing separation and swelling are poorer than in the semiconductor device 1A. Because of this, there are problems that separation between the die pad 3B and the resin package 7, and swelling of the resin package 7 cannot be surely prevented.

In the semiconductor device 1C shown in FIGs. 5 and 6, there is a problem that the heat release efficiency of the semiconductor device 1C is poor. The die pad 3C functions as a stage on which the semiconductor chip 2 is mounted, and also functions as a heat releasing plate for releasing the heat generated in the semiconductor chip 2. If the die pad 3C is small, its function as a heat releasing plate deteriorates, and the heat releasing efficiency of the semiconductor device 1C is lowered accordingly.

### SUMMARY OF THE INVENTION

A general object of the present invention is to provide a semiconductor device and a method of producing the same, in which the above disadvantages are eliminated.

A more specific object of the present invention is to provide a thin semiconductor device in which the bond between the die pad and the resin package is excellent, and a method of producing the semiconductor device.

The above objects of the present invention are achieved by a semiconductor device which includes: a semiconductor chip; a die pad on which the semiconductor chip is mounted via a die bonding material; and a resin package which seals the semiconductor chip and the die pad. The die pad is provided with bond reinforcing members each consisting of a penetrating portion and a step portion. The penetrating portion penetrates the die pad. The step portion is formed within the range of the thickness of the die pad, and there are spaces between the semiconductor chip and the step portion. A part of the resin package is situated in the spaces between the semiconductor chip and the step portion.

The above objects of the present invention are also achieved by a semiconductor device production method which includes the steps of: forming a base member into a lead frame having at least leads and a die pad; and forming a resin package by introducing resin so as to seal at least a semiconductor chip and the die pad, with the semiconductor chip being mounted on the lead frame. In the lead step forming step, the die pad is collectively provided with bond reinforcing members each consisting of a penetrating portion and a step portion. The penetrating portion penetrates the die pad. The step portion is formed within the range of the thickness of the die pad, and is thinner than the die pad. In the package forming step, the resin is introduced into spaces formed between the semiconductor chip and the step portion.

In the above semiconductor device and method, the resin package surrounds the step portion to strengthen the bond between the resin package and the die pad, with a part of the resin package being situated in the spaces between the semiconductor chip and the step portion. Even when heat is applied at the time of mounting, separation at the interface between the resin package and the die pad can be avoided, and the resin package can be prevented from swelling. Thus, the reliability of the semiconductor device can be improved. Also, since the step portion is formed within the range of the thickness of the die pad, the step portion does not make the die pad thicker. Thus, the semiconductor device can remain thin and maintain high reliability at the same time.

The above objects of the present invention are also achieved by a semiconductor device comprising: a semiconductor chip; a die pad onto which the semiconductor chip is mounted via a die bonding material; a resin package which seals the semiconductor chip and the die pad; and bond reinforcing members each including a slit-like penetrating portion which penetrates the die pad, and a step portion formed within a range of a thickness of the die pad in each of the penetrating portion, with spaces being formed between the semiconductor chip and the step portion. The bond reinforcing members is provided to the die pad. A part of the resin package is interposed in the spaces between the semiconductor chip and the step portion.

With this structure, when the resin package is formed, the resin is introduced into the penetrating portion and between the semiconductor chip and the step portion. Since part of the resin package is interposed between the semiconductor chip and the step portion, the step portion is surrounded by the resin package, thereby improving the bond between the resin package and the die pad. Even when heat is applied for mounting, separation on the interface between the resin package and the die pad can be prevented, and the resin package can be prevented from swelling. Thus, the reliability of the semiconductor device can be improved.

Since each penetrating portion has a slit-like shape, the resin is allowed wide spaces to easily pass through the penetrating portion in spite of the step portion. Thus, the resistance caused to the resin flowing into the penetrating portion at the time of the resin package formation can be made smaller, thereby facilitating the resin filling.

When heat is applied (for mounting, for instance) after the resin package formation, stress is normally caused in the die pad due to the thermal expansion difference between the die bonding material and the resin package. In this embodiment, however, the slit-like penetrating portion reduces the stress caused in the die pad. When stress is applied to the die pad, the penetrating portion is deformed, and the stress caused by the thermal expansion difference is thus absorbed by the penetrating portion. Accordingly, even if heat is applied after the resin package formation, separation between the die bonding material and the die pad can be prevented, as well as separation on the interface between the resin package and the die pad, and swelling of the resin package.

The above and other objects and features of the present invention will become more apparent from the following description taken in conjunction with the accompanying drawings.

### BRIEF DESCRIPTION OF THE DRAWINGS

FIG. 1 is a sectional view of a conventional semiconductor device;
FIG. 2 is a plan view of a lead frame used for producing the semiconductor device of FIG. 1;
FIG. 3 is a partially enlarged sectional view of another conventional semiconductor device;
FIG. 4 is a plan view of a lead frame used for producing the semiconductor device of FIG. 3;
FIG. 5 is a partially enlarged sectional view of yet another conventional semiconductor device;
FIG. 6 is a plan view of a lead frame used for producing the semiconductor device of FIG. 5;
FIG. 7 is a sectional view of a semiconductor device of a first embodiment of the present invention;
FIG. 8 illustrates a modification of the semiconductor device of the first embodiment of the present invention;
FIGs. 9A and 9B illustrate a lead frame forming step of a semiconductor device production method of the present invention;
FIGs. 10A and 10B are enlarged views of a bond reinforcing member formed in the lead frame forming step;
FIG. 11 illustrates a package forming step of the semiconductor device production method of the present invention;
FIG. 12 illustrates the package forming step of the semiconductor device production method of the present invention;
FIG. 13 illustrates the package forming step of the semiconductor device production method of the present invention;
FIGs. 14A and 14B are enlarged views of another example of a bond reinforcing member formed in the lead frame forming step;
FIG. 15 is a sectional view of a semiconductor device of a second embodiment of the present invention; and
FIGs. 16A and 16B are enlarged views of yet another example of a bond reinforcing member formed in the lead frame forming step.
FIG. 17 is an enlarged view of still another example of a bond reinforcing member;
FIG. 18 is a sectional view taken along the line A-A of FIG. 17;
FIG. 19 is an enlarged perspective view of the bond reinforcing member of FIG. 17; and
FIG. 20 is an enlarged view of a further example of a bond reinforcing member.

### DESCRIPTION OF THE PREFERRED EMBODIMENTS

The following is a description of embodiments of the present invention, with reference to the accompanying drawings.

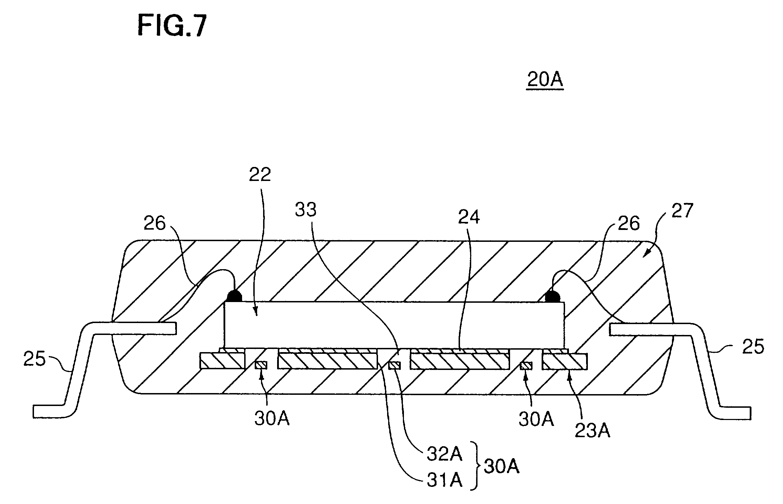

FIG. 7 is a vertical sectional view of a semiconductor device 20A of a first embodiment of the present invention. As shown in the figure, the semiconductor device 20A comprises a semiconductor chip 22, a die pad 23A, leads 25, wires 26, and a resin package 27.

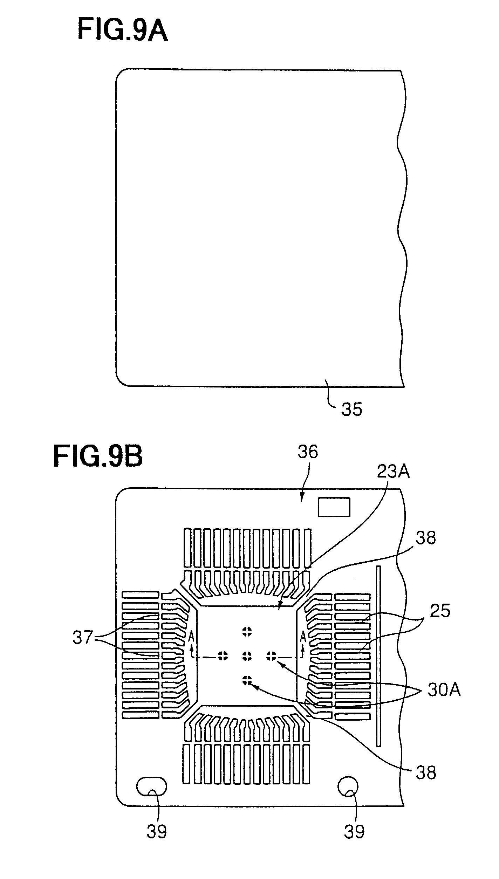

The semiconductor chip 22 is bonded (mounted) to the die pad 23A with a die bonding material 24. The leads 25 are disposed along the outer periphery of the semiconductor chip 22, and the semiconductor chip 22 is electrically connected to the leads 25 by the wires 26. As described later, the die pad 23 and the leads 25 are collectively formed from a lead frame 36 (shown in FIG. 9B), and are made of Cu-Ni-Sn copper alloy (or Fe-Ni alloy), for instance. Since the semiconductor device 20A of this embodiment is a QFP (Quad Flat Package) of a surface mount type, the outer leads of the lead frame 36 are formed like gull wings.

The resin package 27 is made of epoxy resin, for instance, and seals and protects the semiconductor chip 22, the die pad 23, the leads 25 (inner leads), and the wires 26. Also, the resin package 27 is made as thin as possible so that the semiconductor device 20A of this embodiment is thinner than conventional semiconductor devices.

More specifically, the resin package 27 is 1.4 mm or thinner. As a result, the resin package 27 of the thin semiconductor device 20A is lower in strength and rigidity than a resin package of a conventional thick semiconductor device.

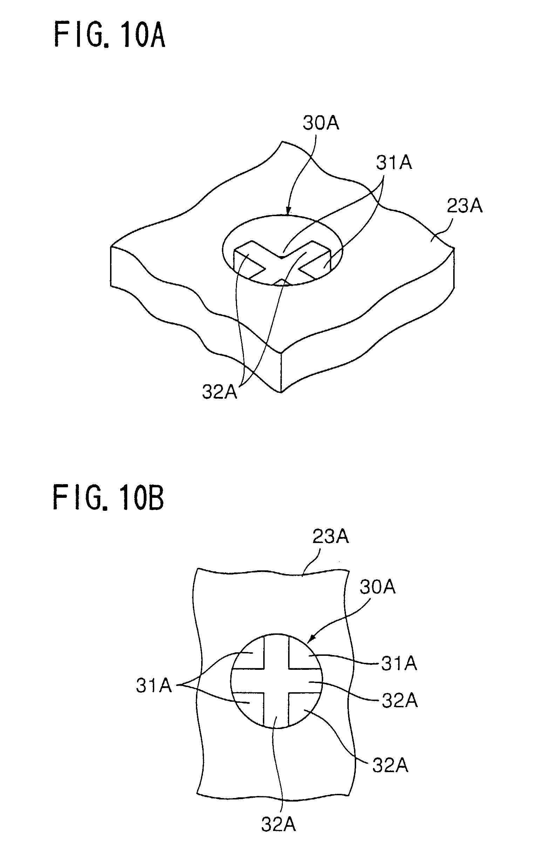

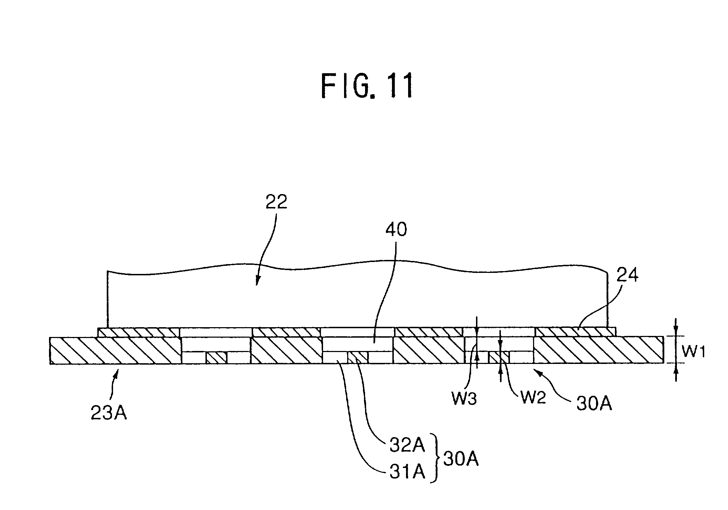

In the following, the die pad 23A will be described in detail, with reference to FIGs. 9B, 10A, 10B, and 11. FIG. 9B shows the lead frame 36 used to produce the semiconductor device 20A. FIGs. 10A and 10B are enlarged views of a bond reinforcing portion 30A described later. FIG. 11 is a sectional view of the die pad 23A prior to the formation of the resin package 27.

The die pad 23A of the semiconductor device 20 of this embodiment is provided with a plurality of bond reinforcing members 30A, as shown in FIG. 9B. Each of the bond reinforcing members 30A is made up of penetrating portions 31A and step portions 32A, as shown in FIGs. 10A and 10B. Each of the penetrating portions 31A vertically penetrates the die pad 23A. Each of the step portions 32A of this embodiment has a cross-like shape on the plan view of FIG. 10B. As shown in FIG. 11, the thickness W2 of each of the step portions 32A is smaller than the thickness W1 of the die pad 23A (W1 > W2). Since the bottom surface of each of the step portions 32A is on the same plane as the bottom surface of the die pad 23A, a space 40 having a thickness W3 (W3 = W1 - W2) is formed above each of the step portions 32A. As a result, the step portions 32A form steps with respect to the upper surface of the die pad 23A (onto which the semiconductor chip 22 is mounted).

As described above, the step portions 32A are formed within the thickness W1 of the die pad 23A, and do not protrude from the upper surface of the die pad 23A. Even with the step portions 32A, the die pad 23A is not thick, thereby maintaining the thinness of the semiconductor device 20A.

Next, the bond between the die pad 23A having the bond reinforcing portions 30A and the resin package 27 will be described.

When the resin package 27 is formed, the resin package 27 is also situated within the penetrating portions 31A and within the spaces 40 above the step portions 32A, because the die pad 23A is provided with the bond reinforcing portions 30A each consisting of the penetrating portions 31A penetrating the die pad 23A and the step portions 32A below the space 40 (hereinafter, the portion situated within the spaces 40 will be referred to as an interposing resin 33).

When the semiconductor chip 22 is mounted on the die pad 23A, the semiconductor chip 22 is placed on the side of the spaces 40. As shown in FIG. 7, the upper part of the interposing resin 33 is in contact with the semiconductor chip 22, and the lower part of the interposing resin 33 surrounds the step portions 32A. Thus, the bond between the resin package 27 and the die pad 23A is improved.

If heat is applied to the semiconductor device 20A at the time of surface mounting, separation at the interface between the resin package 27 and the die pad 23A can be prevented. Also, if the absorbed moisture is turned into vapor, the resin package 27 can be prevented from swelling. Thus, the reliability of the semiconductor device 20A can be improved. More specifically, even if copper alloy having low bonding ability with the resin package 27 is employed for the die pad 23A, the resin package 27 would not be removed from the die pad 23A, because the bond between the die pad 23A and the resin package 27 is strong.

The strong bond between the resin package 27 and the die pad 23A allows the die pad 23A a wide area. Accordingly, the heat resistance of the die pad 23A lowers, and the heat generated in the semiconductor chip 22 can be efficiently released.

As shown in FIG. 9B, the bond reinforcing members 30A formed in the die pad 23A are disposed symmetrically about the center of the die pad 23A. If heat is applied to the semiconductor device 20A and stress is caused in the bond reinforcing members 30A, the stress is applied evenly to the bond reinforcing members 30A instead of being applied only to a certain portion of the bond reinforcing members 30A. Thus, separation between the die pad 23A and the resin package 27, and swelling of the resin package can be effectively prevented.

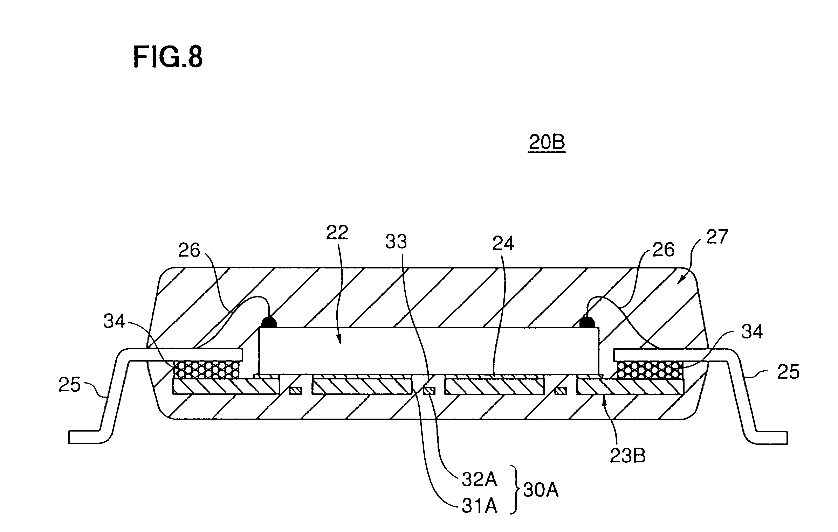

FIG. 8 shows a semiconductor device 20B of a modification of the semiconductor device 20A of FIG. 7. In the semiconductor device 20B, the leads 25 are bonded to a die pad 23B with adhesives 34. The area of the die pad 23B is larger than the area of the die pad 23A of the semiconductor device 20A of the first embodiment, so as to further improve the heat radiation characteristics of the die pad 23B. In this modification, the leads 25 are formed separately from the die pad 23B, and thus different materials suitable for the respective functions can be chosen.

FIGs. 9A to 13 illustrate a method of producing the semiconductor device of the first embodiment. In FIGs. 9A to 13, the same components as in FIG. 7 are indicated by the same reference numerals.

As is well known, a semiconductor production method includes many steps, and so does the method of the present invention. The method of the present invention is different from a conventional semiconductor production method only in a lead frame forming step and a package forming step. Therefore, the following description mainly concerns the two steps.

FIGs. 9A to 10B illustrate the lead frame forming step. To produce the semiconductor device 20A, a substrate 35 shown in FIG. 9A should be first prepared. The substrate 35 is made of copper alloy such as MF-202 or EFTEC-64 (Fe-Ni alloy is also applicable) which is generally employed as a lead frame substrate for a semiconductor device.

The substrate 35 is stamped so as to form the lead frame 36 shown in FIG. 9B. The lead frame 36 comprises the leads 25 to be wire-bonded to the semiconductor chip 22, the die pad 23A, support bars 38 for supporting the die pad 23, positioning holes 39, and the bond reinforcing members 30A for reinforcing the bond between the resin package 27 and the die pad 23A. The leads 25 in the lead frame 36 are secured by die bars 37.

The lead frame forming step of this embodiment is characterized in that the bond reinforcing members 30A are collectively formed with the leads 25, the die pad 23A, the support bars 38, and the positioning holes 39 by stamping. Since each of the bond reinforcing members 30A is simply made up of the penetrating portions 31A and the step portions 32A, the bond reinforcing members 30A can be formed by stamping (machining).

Accordingly, there is no need to employ a special step for forming the bond reinforcing members 30A, which can thus be easily and efficiently produced at low cost. The bond reinforcing members 30A can also be produced by other methods such as etching, but stamping (machining) can be more efficiently performed at lower cost.

The penetrating portions 31A and the step portions 32A are not necessarily formed at the same time. When forming the bond reinforcing members 30A in the lead frame forming step, the penetrating portions 31A are first formed by stamping, and the positions to be the step portions 32A of the die pad 23A are then crushed to form the step portions 32A.

By the above procedures, the deformation (elongation) of the step portions 32A caused by the crushing of the step portions 32A escapes to the penetrating portions 31A. Thus, the bond reinforcing members 30A provided to the die pad 23A can prevent the die pad 23A from being deformed or warped, while maintaining the flatness of the die pad 23A.

The above lead frame is then plated in a predetermined manner, and the semiconductor chip 22 is mounted onto the die pad 23A via the die bonding material 24. Here, the die bonding material 24 is applied to the die pad 23A except the area of the bond reinforcing members 30A, so that the die bonding material 24 can be prevented from attaching to the penetrating portions 31A and the step portions 32A.

If the die bonding material 24 attaches to and buries the penetrating portions 31A and the step portions 32A, the bond between the die pad 23A and the resin package 27 cannot be strengthened enough. By applying the die bonding material 24 to the die pad 23A except the areas of the bond reinforcing members 30A, the bond between the resin package 27 and the bond reinforcing members 30A is maintained, and the bond between the die pad 23A and the resin package 27 can be surely improved.

With the semiconductor chip 22 being mounted on the die pad 23A, the wires 26 are wire-bonded between the semiconductor chip 22 and the leads 25. The lead frame 36, on which the semiconductor chip 22 is mounted, is then attached to a metal mold for resin molding (not shown), and the package forming step is carried out.

FIGs. 11 to 13 illustrate the package forming step. In these figures, only the neighborhood area of the die pad 23A is enlarged for ease of explanation.

FIG. 11 illustrates the die pad 23A prior to the filling of resin 41 to be the resin package 27. As described before, with the semiconductor chip 22 being mounted on the die pad 23A, there are spaces 40 indicated by W3 between the step portions 32A and the semiconductor chip 22.

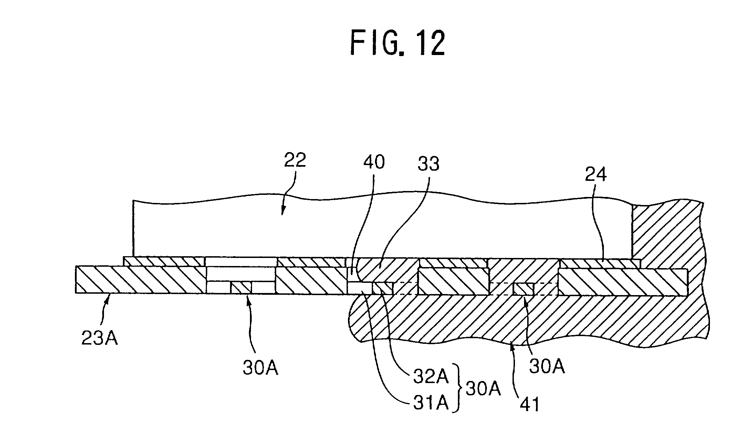

FIG. 12 illustrates the die pad 23A, with the resin 41 to be the resin package 27 being introduced (filled). As described before, each of the bond reinforcing members 30A is made up of the penetrating portions 31A and the step portions 32A, and the space 40 above the step portions 32A communicates with the outside via the penetrating portions 31A. The resin 41 is introduced and interposed in the spaces 40 so as to form the interposing resin 33.

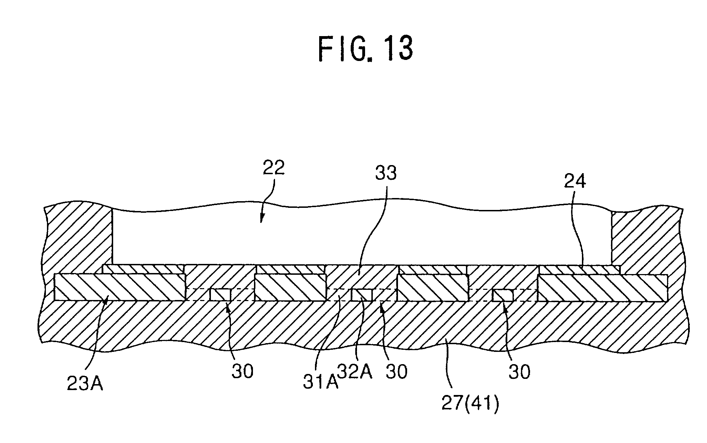

FIG. 13 illustrates the die pad 23A after the resin package 27 has been formed. As shown in the figure, the interposing resin 33 that is a part of the resin package 27 surrounds the step portions 32A, so that the bond between the resin package 27 and the die pad 23A can be improved. If heat is applied to the semiconductor device 20A at the time of mounting, separation at the interface between the resin package 27 and the die pad 23A can be prevented. Also, if the absorbed moisture is turned into vapor, the resin package 27 can be prevented from swelling. Thus, the reliability of the semiconductor device 20A can be improved.

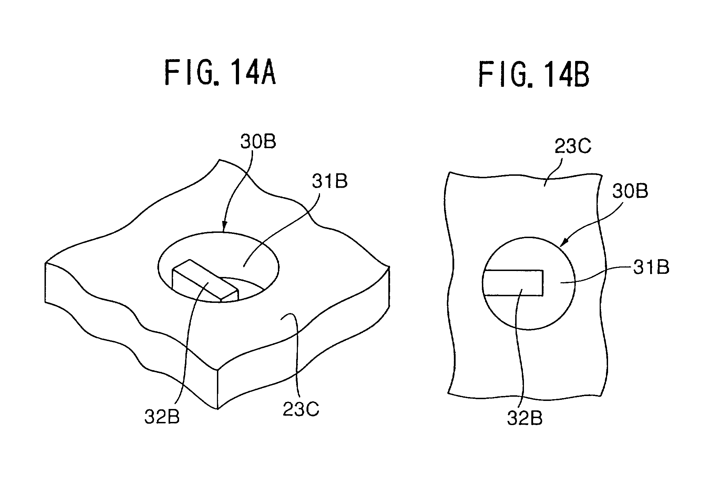

FIGs. 14A to 20 illustrate other examples of the bond reinforcing members.

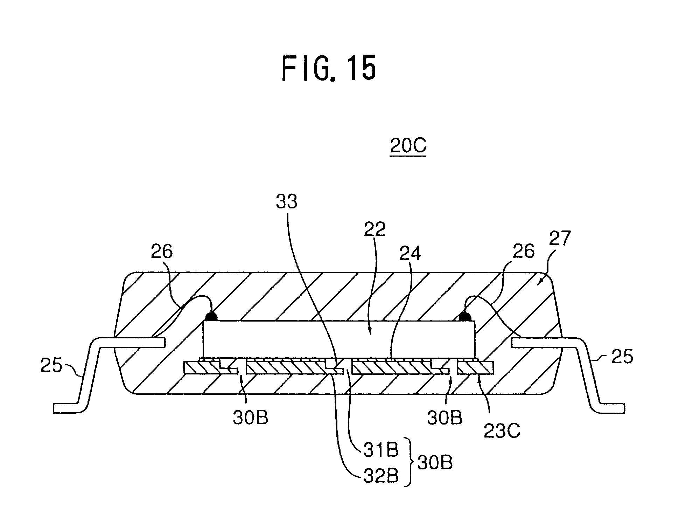

FIGs. 14A and 14B shows bond reinforcing members 30B. FIG. 15 shows a semiconductor device 20C of a second embodiment of the present invention which is characterized by the bond reinforcing members 30B.

The bond reinforcing members 30A shown in FIGs. 10A and 10B have the cross-shaped step portions 32A. The bond reinforcing members 30B of this embodiment are characterized in that step portions 32B are cantilevered and extend into penetrating portions 31B. With the bond reinforcing members 30B, the penetrating portions 31B become wider, and the interposing resin 33 is surely introduced into the spaces 40 so as to surround the step portions 32B. Thus, the bond between the resin package 27 and a die pad 23C can be further improved.

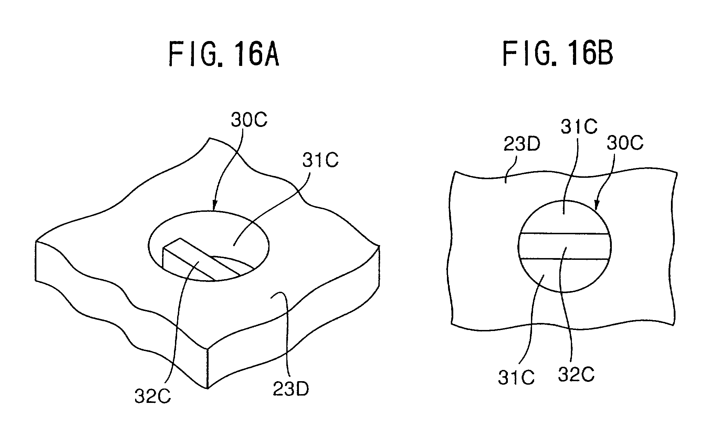

FIGs. 16A and 16B show bond reinforcing members 30C which are characterized in that step portions 32C are supported at both ends. The bond reinforcing members 30B having the cantilevered step portions 32B shown in FIGs. 14A and 14B might be deformed if the die pad 23C is thin. Depending on the condition of the deformation, the bond between the resin package 27 and the die pad 23C is lowered. The step portions 32 supported at both ends maintain the effects of the bond reinforcing members 30B and prevent the step portions 32C from being deformed. Thus, a strong bond between the resin package 27 and a die pad 23D can be maintained.

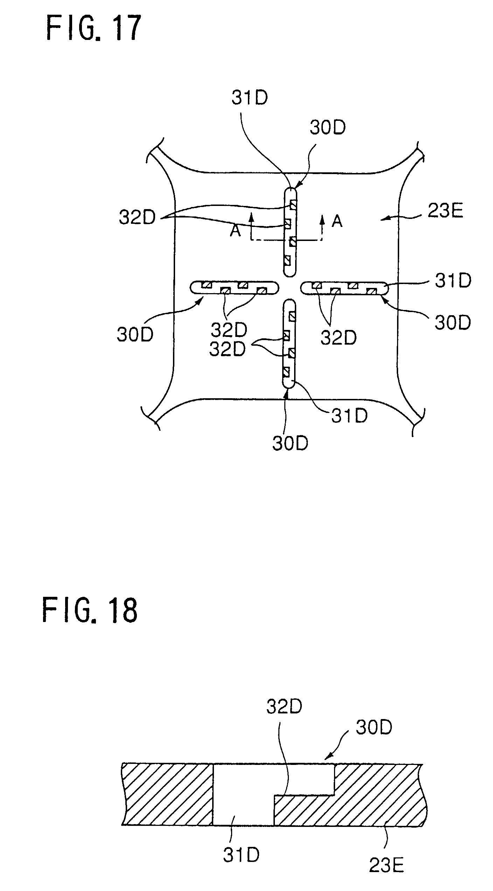

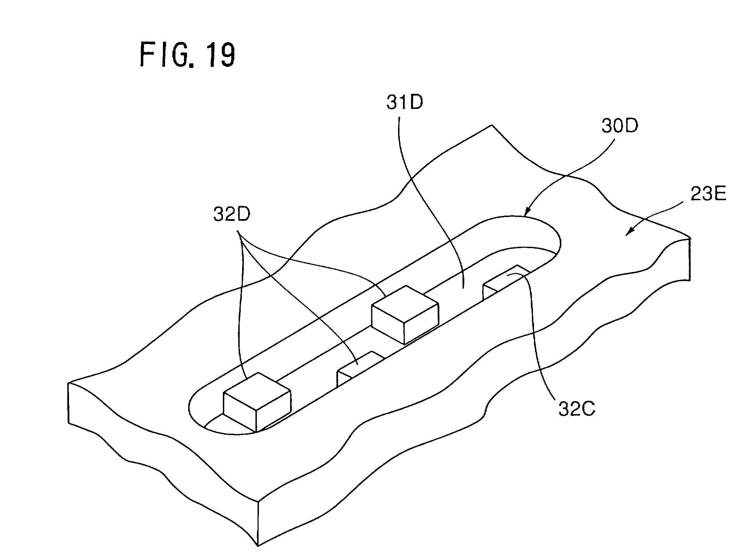

FIGs. 17 to 19 illustrate bond reinforcing members 30D. FIG. 17 is a plan view of a die pad 23E provided with the bond reinforcing members 30D. FIG. 18 is a sectional view taken along the line A-A of FIG. 17. FIG. 19 is an enlarged perspective view of one of the bond reinforcing members 30D.

The bond reinforcing members 30D of the present invention each have a slit-like rectangular penetrating portion 31D. A plurality of step portions 32D are formed in each penetrating portion 31D. In FIG. 17, four slit-like penetrating portions 31D penetrate through the die pad 23E, and form a cross-like shape. The step portions 32D are formed alternately on both inner long surfaces of each slit-like penetrating portion 31D. Each of the step portions 32D is thinner than the die pad 23E, and forms a step lower from the surface of the die pad, as shown in FIG. 18.

As in the foregoing examples, when forming the resin package 27 (not shown), the resin is introduced into the penetrating portions 31D and between the semiconductor chip 22 (not shown) and the step portions 32D. As a result, the step portions 32D are surrounded by the resin package 27, thereby enhancing the bond between the resin package and the die pad 23E. Even when heat is applied during the mounting process, separation on the interface between the resin package and the die pad 23E can be avoided, and the resin package 27 can be prevented from swelling. Thus, the reliability of the semiconductor device can be improved.

Since each of the penetrating portions 31D has a slit-like shape, the resin is allowed wide spaces to easily pass through the penetrating portions 31D in spite of the step portions 32D. Thus, the resistance caused to the resin flowing into the penetrating portions 31D at the time of the resin package formation can be made smaller, thereby facilitating the resin filling.

When heat is applied (for mounting, for instance) after the resin package formation, stress is normally caused in the die pad 23E due to the thermal expansion difference between the die bonding material 24 (shown in FIG. 7) and the resin package 27. In this embodiment, however, the slit-like penetrating portions 31D reduce the stress caused in the die pad 23E. When stress is applied to the die pad 23E, the penetrating portions 31D are deformed (i.e., the resin inside the penetrating portions 31D is bent), and the stress caused due to the thermal expansion difference is thus absorbed by the penetrating portions 31D. Accordingly, even if heat is applied after the resin package formation, separation between the die bonding material 24 and the die pad 23E can be prevented, as well as separation on the interface between the resin package 27 and the die pad 23E, and swelling of the resin package 27. Thus, the reliability of the semiconductor device can be further improved.

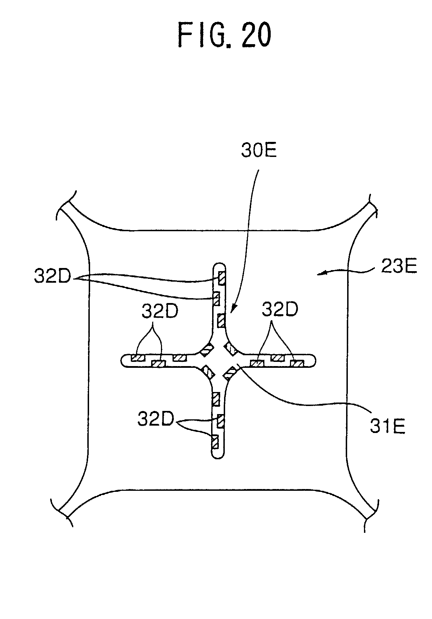

FIG. 20 is a plan view of a die pad 23F provided with bond reinforcing members 30E. In FIG. 20, the same components as shown in FIGs. 17 to 10 are shown by the same reference numerals.

The bond reinforcing members 30E are characterized by four penetrating portions 31E connected at end portions in the center of the die pad 23F. By connecting the end portions of the four penetrating portions 31E, the stress reducing effect of the penetrating portions 31E can be improved, and separation on the interface between the die bonding material 24 and the die pad 23E can be surely prevented.

The structures of the step portions of the bond reinforcing members are not limited to the above structures, but other structures may be employed as long as the resin package surrounds the step portions so as to improve the bond between the resin package and the die pad.

Although the present invention has been fully described by way of examples with reference to the accompanying drawings, it is to be noted that various changes and modifications will be apparent to those skilled in the art. Therefore, unless otherwise such changes and modifications depart from the scope of the present invention, they should be construed as being included therein.

The present application is based on Japanese priority applications No. 11-20457, filed on January 28, 1999 and No. 11-241477, filed on August 27, 1999, the entire contents of which are hereby incorporated by reference.

## Claims

1. A semiconductor device comprising:
a semiconductor chip;
a die pad onto which the semiconductor chip is mounted via a die bonding material;
a resin package which seals the semiconductor chip and the die pad; and
bond reinforcing parts each including a penetrating portion which penetrates the die pad, and a step portion formed within a range of a thickness of the die pad, with spaces being formed between the semiconductor chip and the step portion, the bond reinforcing parts being provided to the die pad,
wherein a part of the resin package is interposed in the spaces between the semiconductor chip and the step portion.

2. The semiconductor device according to claim 1, wherein the part of the resin package surrounds the step portion.

3. The semiconductor device according to claim 1, wherein the bond reinforcing parts are arranged symmetrically about a center of the die pad.

4. A method of producing a semiconductor device, comprising the steps of:
forming a base member into a lead frame which comprises at least leads and a die pad; and
forming a resin package by disposing resin so as to seal the semiconductor chip and the die pad after a semiconductor chip is mounted onto the lead frame,
wherein:
bond reinforcing parts each comprising a penetrating portion which penetrates the die pad, and a step portion formed within a range of a thickness of the die pad, are collectively formed in the die pad in the step of forming the base member into the lead frame; and
the resin is disposed in spaces formed between the semiconductor chip and the step portion in the step of forming the resin package.

5. The method according to claim 4, wherein the leads, the die pad, and the bond reinforcing parts are formed by stamping in the step of forming the base member into the lead frame.

6. The method according to claim 5, wherein the penetrating portion is formed by punching, and the step portion is formed by crushing portions to be the step portion, thereby forming the bond reinforcing parts in the lead frame forming step.

7. A semiconductor device comprising:
a semiconductor chip;
a die pad onto which the semiconductor chip is mounted via a die bonding material;
a resin package which seals the semiconductor chip and the die pad; and
bond reinforcing parts each including a slit-like penetrating portion which penetrates the die pad, and a step portion formed within a range of a thickness of the die pad in the penetrating portion, with spaces being formed between the semiconductor chip and the step portion, the bond reinforcing parts being provided to the die pad,
wherein a part of the resin package is interposed in the spaces between the semiconductor chip and the step portion.
